# FASCICULE DE BREVET EUROPEEN

(11) **EP 0 950 257 B1**
(45) Date de publication et mention de la délivrance du brevet: **16.09.2009**
(21) Numéro de dépôt: 97913241.2
(22) Date de dépôt: 04.11.1997
(51) Int. Cl.: H01L 21/20, H01L 21/762, H01L 21/304

(54) **PROCEDE DE FABRICATION D'UN FILM MINCE SUR UN SUPPORT**
VERFAHREN ZUR HERSTELLUNG VON EINER DÜNNSCHICHT AUF EINEM TRÄGER
METHOD FOR MAKING A THIN FILM ON A SUPPORT

(30) Priorité: 05.11.1996 FR 9613449
(43) Date de publication de la demande: 20.10.1999
(73) Titulaire: COMMISSARIAT A L'ENERGIE ATOMIQUE, 75015 Paris (FR)
(72) Inventeur: ASPAR, Bernard, F-38140 Rives (FR); BRUEL, Michel, F-38113 Veurey (FR); BARGE, Thierry, F-38000 Grenoble (FR)
(74) Mandataire: Audier, Philippe André
(86) Numéro de dépôt international: PCT/FR1997/001969
(87) Numéro de publication internationale: WO 1998/020543

(56) Documents cités:
- EP-A- 0 504 714
- EP-A- 0 533 551
- EP-A- 0 703 609
- TAKAO ABE ET AL: "334 - 337" JAPANESE JOURNAL OF APPLIED PHYSICS, vol. 32, no. 1B, PART 01, 1 janvier 1993, pages 334-337, XP000418031
- ABE T ET AL: "THINNED SILICON LAYERS ON OXIDE FILM, QUARTZ AND SAPPHIRE BY WAFER BONDING" IEICE TRANSACTIONS ON ELECTRONICS, vol. E77-C, no. 3, 1 mars 1994, pages 342-349, XP000451422
- PATENT ABSTRACTS OF JAPAN vol. 095, no. 008, 29 septembre 1995 -& JP 07 130590 A (SHIN ETSU HANDOTAI CO LTD;OTHERS: 01), 19 mai 1995,

## Description

### Domaine technique

La présente invention concerne un procédé de fabrication d'un film mince de matériau solide sur un support, en particulier lorsque ce matériau solide et ce support présentent des comportements thermiques différents. Le film mince peut être en matériau semiconducteur ou non. L'invention concerne également la structure obtenue par ce procédé de fabrication.

### Etat de la technique antérieure

On connaît de nombreux procédés de réalisation de films minces de matériau solide. Ces procédés dépendent de la nature du matériau et de l'épaisseur du film désiré. On peut ainsi déposer des films minces d'un matériau solide sur la surface d'une pièce par projection, pulvérisation, électrodéposition, etc. On peut aussi obtenir un film mince en amincissant une plaquette du matériau désiré par abrasion mécanochimique ou chimique, le film mince obtenu étant ensuite collé ou fixé sur une pièce servant de support.

Généralement, la fixation d'un film mince sur la surface d'une pièce est destinée à modifier superficiellement les propriétés de la pièce.

Dans le domaine des semiconducteurs, on est aussi quelquefois amené à réaliser des films minces de semiconducteurs, par exemple pour fabriquer des substrats dits "Silicium Sur Isolant". Différentes méthodes de réalisation de films minces semiconducteurs ont été développées. L'une des méthodes les plus récentes est basée sur le fait que l'implantation d'ions d'un gaz rare ou d'hydrogène dans un matériau semiconducteur induit la formation de zones fragilisées à une profondeur voisine de la profondeur moyenne de pénétration des ions. Le document FR-A-2 681 472 divulgue un procédé qui utilise cette propriété pour obtenir un film mince de matériau semiconducteur. Ce procédé consiste à soumettre une plaquette du matériau semiconducteur désiré et comportant une face plane aux étapes suivantes :
- une première étape d'implantation par bombardement de la face plane de la plaquette au moyen d'ions créant, dans le volume de la plaquette et à une profondeur voisine de la profondeur de pénétration des ions, une couche de "microbulles gazeuses" séparant la plaquette en une région inférieure constituant la masse du substrat et une région supérieure constituant le film mince, les ions étant choisis parmi les ions de gaz rares ou de gaz hydrogène ;
- une deuxième étape de mise en contact intime de la face plane de la plaquette avec un support (ou raidisseur) constitué au moins d'une couche de matériau rigide. Ce contact intime pouvant être réalisé par exemple à l'aide d'une substance adhésive, par l'effet d'une préparation préalable des surfaces et d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créner une séparation entre le film mince et la masse du substrat. Cette température est d'environ 400°C pour du silicium.

Dans ce document, on propose l'explication suivante aux différents phénomènes constatés par l'expérience. Tout d'abord, la première étape d'implantation ionique est menée en présentant à un faisceau d'ions une face plane d'une plaquette de matériau semiconducteur, le plan de cette face plane étant soit sensiblement parallèle à un plan cristallographique principal dans le cas où le matériau semiconducteur est parfaitement monocristallin, soit faiblement incliné par rapport à un plan cristallographique principal de mêmes indices pour tous les grains dans le cas où le matériau est polycristallin. On crée ainsi dans le volume de la plaquette, à une profondeur voisine de la profondeur moyenne de pénétration des ions, une couche de "microbulles gazeuses" délimitait, dans le volume de la plaquette deux régions séparées par cette couche : une région destinée à constituer le film mince et une région formant le reste du substrat. Par l'expression "microbulle gazeuse" on entend toute cavité ou microcavité générée par l'implantation d'ions de gaz hydrogène ou de gaz rares dans le matériau. Les cavités peuvent se présenter sous forme très aplatie, c'est-à-dire de faible hauteur, par exemple de l'ordre de quelques distances inter-atomiques, aussi bien que sous forme sensiblement hémisphérique ou sous tout autre forme différente des deux formes précédentes. Ces cavités peuvent ou non contenir une phase gazeuse. Au cours de la troisième étape, le traitement thermique est réalisé à une température suffisante pour créer, par effet de réarrangement cristallin dans le matériau semiconducteur tel que par exemple par effet de croissance des microcavités et/ou par effet de pression des microbulles, la séparation entre les deux régions.

En fait, il semble que ce procédé peut s'appliquer à tous les types de matériaux solides, cristallins ou non. Il est possible d'appliquer ce procédé à des matériaux diélectriques, conducteurs, semi-isolants, ainsi qu'à des matériaux semiconducteurs amorphes. En outre, ce procédé ne modifie pas fondamentalement les propriétés du matériau auquel il s'applique.

L'implantation d'ions de gaz hydrogène ou de gaz rares peut donc aussi provoquer la formation de microcavités dans des matériaux solides autres qu'un matériau semiconducteur cristallin, et un traitement thermique subséquent peut provoquer un clivage dans la masse du matériau si l'étape d'implantation a été menée de façon à obtenir une couche de microcavités.

En outre, l'étape de traitement thermique qui permet le clivage est définie préférentiellement par rapport à un budget thermique qui dépend du budget thermique de l'étape d'implantation ionique et de la dose et de l'énergie des ions implantés et éventuellement d'autres budgets thermiques induits par d'autres étapes. Ainsi, dans certains cas on peut avoir un recuit à une température inférieure à celle de l'implantation.

Cependant, l'application de ce procédé peut présenter certains problèmes lorsque le substrat dans lequel on a délimité un film mince et le raidisseur ont des coefficients de dilatation thermique différents ou du moins trop différents. En effet, dans ce cas, il existe, au cours de l'étape de traitement thermique, une compétition entre les forces d'adhérence maintenant le substrat implanté et le raidisseur en contact intime, les forces dues aux différences de coefficients de dilatation thermique (qui ont tendance à séparer le substrat du raidisseur) et les forces qui conduisent à la fracture au niveau des microcavités induites par l'implantation d'ions.

A priori, il n'est pas évident de prévoir le mécanisme qui prédomine au cours de l'étape de traitement thermique. Cependant, les inventeurs de la présente invention ont mis en évidence le fait qu'il peut se produire une séparation au niveau de l'interface de mise en contact du substrat et du raidisseur au cours de ce traitement thermique et non au niveau de la zone de microcavités lorsque les matériaux constituant le substrat et le raidisseur ont des coefficients de dilatation thermique différents.

Pour la mise en oeuvre du procédé de réalisation d'un film mince selon le document FR-A-2 681 472, on peut poser comme définition que deux matériaux ont des coefficients de dilatation thermique différents dans une gamme de température donnée, lorsque la mise en contact intime de ces deux matériaux, formant des éléments d'épaisseurs considérées comme voisines ne supportent pas un traitement thermique dans la gamme de température donnée. Ce phénomène se traduit alors par la séparation des deux éléments.

Le document "Fabrication and Bonding Strength of Bonded Silicon-Quartz Wafers" de T. ABE et al., Japanese Journal of Applied Physics, Vol. 32, N° 1B, Part 01, 1er janvier 1993, pages 334 à 337, décrit le collage par adhésion moléculaire d'une plaquette de silicium et d'une plaquette de quartz et le renforcement du collage par un traitement thermique. Pour éviter les phénomènes de cassure lors du traitement thermique, il est préconisé de réduire l'épaisseur de la plaquette de silicium au moyen d'une succession d'étapes de chauffage à des températures intermédiaires associées à des étapes d'amincissement.

### Exposé de l'invention

Pour remédier à cet inconvénient, on propose selon la présente invention d'appliquer l'étape de traitement thermique à l'ensemble constitué par le raidisseur et le substrat implanté mis en contact intime lorsqu'au moins l'un de ces éléments a été mis sous forme d'une couche mince. Dans ce cas, la couche mince est suffisamment élastique pour subir la déformation induite par l'autre matériau sans que les deux matériaux ne se séparent.

On propose donc de jouer sur l'épaisseur de l'un des éléments de l'ensemble pour que cet élément, rendu suffisamment mince, puisse suivre les déformations imposées par l'autre élément pendant l'étape de traitement thermique. Un clivage dans le plan des microcavités pourra donc se produire sans problème pour fournir le film mince désiré.

L'invention a donc pour objet un procédé de fabrication d'un film mince en un premier matériau sur un support en un deuxième matériau, comprenant :
- une étape d'implantation ionique au cours de laquelle une face d'un substrat dudit premier matériau est bombardée par des ions afin de créer, dans le volume du substrat et à une profondeur voisine de la profondeur moyenne de pénétration des ions, une couche de microcavités séparant le substrat en deux régions, la région située entre ladite face bombardée du substrat et la couche de microcavités constituant le film mince,
- une étape de fixation par mise en contact intime de ladite face bombardée du substrat avec une face correspondante du support,
- une étape finale de traitement thermique destinée à porter la couche de microcavités à une température suffisante pour provoquer une séparation entre les deux régions du substrat,
   le procédé comprenant les étapes suivantes :

- une étape consistant à fixer le substrat dudit premier matériau, présentant deux faces principales parallèles, sur un premier élément support par mise en contact intime de l'une des faces principales du substrat avec une face correspondante du premier élément support,
- une étape d'amincissement, consistant à amincir ledit substrat à partir de son autre face principale,
   l'épaisseur du substrat aminci étant telle que l'ensemble constitué par les éléments fixés entre eux par ladite mise en contact intime peut subir l'étape de traitement thermique provoquant ladite séparation tout en préservant ledit contact intime malgré les contraintes induites dans lesdits éléments et résultant de la différence de leur coefficient de dilatation thermique,
- une étape consistant à réaliser l'implantation ionique, au cours de laquelle la face principale libre du substrat aminci est bombardée par des ions,
- une étape consistant à fixer le substrat aminci sur un deuxième élément support par mise en contact intime de la face bombardée avec une face correspondante du deuxième élément support,
- une étape finale consistant à réaliser le traitement thermique destiné à porter la couche de microcavités à une température suffisante pour provoquer un clivage le long de la couche de microcavités.

Avantageusement, les ions utilisés lors de l'étape d'implantation sont choisis parmi les ions de gaz rares et de gaz hydrogène.

L'amincissement peut être effectué par une technique de rodage mécanique, de polissage mécano-chimique ou par attaque chimique, ou par une combinaison de ces techniques.

Dans une étape de fixation, la mise en contact intime peut être obtenue par des forces électrostatiques ou encore par l'utilisation d'une colle ou encore par une technique de collage par adhésion moléculaire renforcé par recuit à une température inférieure à la température minimale qui permet de provoquer une séparation entre les deux régions du substrat. Ce recuit renforçant l'adhésion moléculaire peut être effectué en plusieurs phases alternant avec des phases d'amincissement.

Par le terme de substrat, on entend aussi bien une structure monolithique qu'une structure multicouche.

L'invention s'applique particulièrement au cas où le premier matériau, constituant le film mince, est en silicium et où le deuxième matériau, constituant le support, est en silice.

### Brève description des dessins

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 illustre l'étape d'implantation ionique du procédé,
- la figure 2 illustre l'étape de mise en contact intime du procédé,
- la figure 3 illustre l'étape d'amincissement du procédé,
- la figure 4 illustre l'étape finale de traitement thermique.

### Description détaillée d'un exemple utile à la compréhension de l'invention

Dans la suite de la description, et à titre d'exemple, l'étape d'amincissement concernera le substrat dans lequel est élaboré, par implantation ionique, le film mince. Cet amincissement doit correspondre à un compromis entre un amincissement minimum du substrat, qui est nécessaire pour éviter que le film mince ne se sépare du support lors de l'étape de traitement thermique, et un amincissement maximum au delà duquel il y a risque, au cours du traitement thermique, de migration des microbilles (microcavités) vers la surface du substrat aminci avec pour conséquence la formation de cloques.

Le substrat n'est pas obligatoirement un substrat semiconducteur. Lorsque le substrat est semiconducteur, il peut comporter des éléments de circuits intégrés.

L'application du procédé divulgué par le document FR-A-2 681 472 au report de silicium par exemple monocristallin sur un support (ou raidisseur) peut s'effectuer de manière tout à fait différente selon la nature du matériau constituant le support. Si le support doit être en verre, on peut trouver des compositions de verre telles que les coefficients de dilatation thermique sont suffisamment proches de ceux du silicium. Par exemple, du verre utilisé pour la réalisation d'écrans à cristaux liquides présente un coefficient linéaire de dilatation thermique de 4,3.10⁻⁶/°C alors que le même coefficient est de 2,6.10⁻⁶/°C pour le silicium. Ces coefficients sont suffisamment proches pour que le procédé décrit dans le document FR-A-2 681 472 puisse être appliqué sans problème, l'étape de traitement thermique pouvant être menée entre 300 et 600°C.

Si le support est en silice pure, des problèmes peuvent survenir. En effet, la silice pure a un coefficient linéaire de dilatation thermique trop différent de celui du silicium (5.10⁻⁷/°C) pour qu'une plaquette de silicium de 525 µm d'épaisseur par exemple mise en contact intime avec une plaquette de silice pure de 500 µm d'épaisseur puisse subir un traitement thermique à une température supérieure à 200°C. Lors d'un traitement thermique, la plaquette de silice pure ne se dilate pratiquement pas par rapport à la plaquette en silicium. Il en résulte l'apparition, lors du traitement thermique, de contraintes mécaniques élevées qui provoquent le décollement des plaquettes.

Par contre, le procédé selon la présente invention permet d'obtenir un film mince de silicium sur un support en silice. Ce procédé va être décrit plus en détail ci-dessous dans l'une de ses variantes d'application.

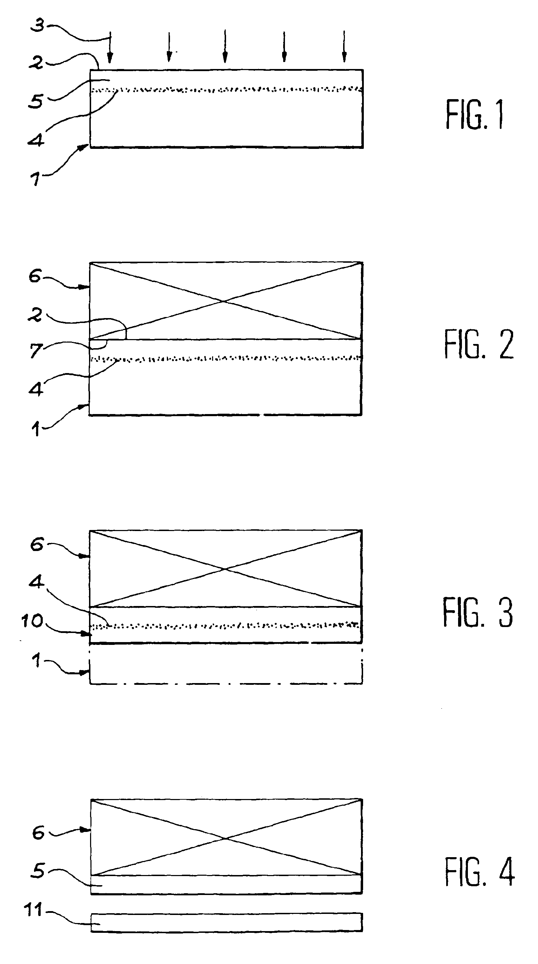

En se reportant à la figure 1, un substrat de silicium 1 est soumis, au travers de l'une de ses faces principales référencée 2, à un bombardement d'ions portant la référence générale 3. Les ions peuvent être des ions hydrogène implantés selon une dose de 5.10¹⁶/cm² et une énergie de 150 keV. On crée ainsi une couche 4 dite de microbulles gazeuses à une profondeur voisine de la profondeur moyenne de pénétration des ions. La région 5 située entre la face 2 et la couche 4 constituera le film mince.

Le substrat de silicium 1 est ensuite mis en contact intime avec un support 6, la face 2 du substrat 1 étant adjacente à la face 7 du support 6. Cette mise en contact intime peut être réalisée par tout moyen connu, les surfaces des faces 2 et 7 ayant été préparées en conséquence. A titre d'exemple, la mise en contact intime peut être obtenue par adhésion moléculaire après nettoyage des surfaces de façon appropriée ou par utilisation d'un film de colle époxy, ou encore par pression de type électrostatique.

Il peut être utile à ce stade de soumettre l'ensemble substrat-support à un recuit qui a pour objet de renforcer les forces de liaison entre le substrat 1 et le support 6. La température de ce recuit doit être suffisante pour augmenter les forces d'adhésion entre les deux éléments mais inférieure à la température qui conduit à la séparation du film mince 5 du reste du substrat.

L'étape suivante consiste en l'amincissement du substrat de silicium 1. Cet amincissement peut se faire par polissage, par rodage mécanique ou mécano-chimique. Ces techniques d'amincissement peuvent être combinées. Par exemple, on peut employer le rodage pour amincir la plaque de quelques centaines de µm. Le rodage créant des défauts d'écrouissage sur quelques µm, ceux-ci peuvent être enlevés par attaque chimique. Dans le cas du silicium, on peut utiliser comme solution d'attaque l'hydroxyde de tétraméthylammonium qui, à 80°C, possède une vitesse d'attaque de l'ordre de 20 µm/h. L'amincissement final obtenu doit être tel que l'épaisseur de silicium restant soit suffisamment élastique pour supporter les contraintes induites par la température imposée lors de l'étape finale du procédé.

Cette étape d'amincissement peut être effectuée, comme il a été dit plus haut, avant la mise en contact du substrat 1 et du support 6, et même avant l'étape d'implantation du substrat 1.

La figure 3 montre l'ensemble substrat-support après amincissement du substrat 1, la masse enlevée du substrat étant représentée en trait interrompu et la partie amincie portant la référence 10.

Afin de renforcer les forces de liaison entre le substrat 1 et le support 6, il peut être avantageux d'effectuer une opération de recuit en plusieurs phases alternant avec des phases d'amincissement avec élévation progressive de la température de recuit. Dans le cas d'un substrat en silicium et d'un support en silice pure, on peut avoir les recuits suivants après mise en contact de ces deux éléments et dans le cas d'un collage par adhésion moléculaire d'un support et d'un substrat ayant chacun 500 µm d'épaisseur environ :
- premier recuit à 100°C pendant plusieurs heures,
- amincissement du substrat implanté de façon à obtenir une épaisseur inférieure à 100 µm,
- deuxième recuit à 200°C pendant plusieurs heures,
- amincissement du substrat implanté de façon à obtenir une épaisseur inférieure à 40 µm.

Lors de la dernière étape, on procède à un traitement thermique isotherme qui chauffe de façon homogène l'ensemble constitué par le support 6 et la partie amincie 10 du substrat semiconducteur 1 à une température suffisante pour créer par effet de réarrangement cristallin et de pression dans les microbulles une séparation entre le film mince 5 et le reste 11 de la partie amincie 10. C'est ce que montre la figure 4.

En mettant en oeuvre le procédé selon la présente invention, la partie amincie 10 a pu subir les contraintes de dilatation thermique imposées par le support 6 lors de l'étape finale sans se décoller du support. La séparation de la masse de silicium en deux parties dans le plan des microbulles gazeuses s'est effectuée correctement pour fournir un film mince de silicium 5 adhérant à un support en silice 6.

Dans le cas où l'on choisit d'amincir le support en parallèle ou à la place du substrat, on opère de la même façon que précédemment décrit pour le substrat.

La description ci-dessus n'est qu'un exemple utile à la compréhension de l'invention, qui consiste à exécuter le procédé selon la revendication 1.

## Revendications

1. Procédé de fabrication d'un film mince en un premier matériau sur un support en un deuxième matériau, comprenant :
- une étape d'implantation ionique au cours de laquelle une face (2) d'un substrat (1) dudit premier matériau est bombardée par des ions (3) afin de créer, dans le volume du substrat et à une profondeur voisine de la profondeur moyenne de pénétration des ions, une couche de microcavités (4) séparant le substrat (1) en deux régions, la région située entre ladite face bombardée (2) du substrat (1) et la couche de microcavités (4) constituant le film mince (5),
- une étape de fixation par mise en contact intime de ladite face bombardée (2) du substrat (1) avec une face correspondante du support (6),
- une étape finale de traitement thermique destinée à porter la couche de microcavités (4) à une température suffisante pour provoquer une séparation entre les deux régions du substrat (1),
**caractérisé en ce qu'**il comprend les étapes suivantes :
- une étape consistant à fixer le substrat dudit premier matériau, présentant deux faces principales parallèles, sur un premier élément support par mise en contact intime de l'une des faces principales du substrat avec une face correspondante du premier élément support,
- une étape d'amincissement, consistant à amincir ledit substrat à partir de son autre face principale,
l'épaisseur du substrat aminci étant telle que l'ensemble constitué par les éléments fixés entre eux par ladite mise en contact intime peut subir l'étape de traitement thermique provoquant ladite séparation tout en préservant ledit contact intime malgré les contraintes induites dans lesdits éléments et résultant de la différence de leur coefficient de dilatation thermique,
- une étape consistant à réaliser l'implantation ionique, au cours de laquelle la face principale libre du substrat aminci est bombardée par des ions,
- une étape consistant à fixer le substrat aminci sur un deuxième élément support par mise en contact intime de la face bombardée avec une face correspondante du deuxième élément support,
- une étape finale consistant à réaliser le traitement thermique destiné à porter la couche de microcavités à une température suffisante pour provoquer un clivage le long de la couche de microcavités.

2. Procédé selon la revendication 1, **caractérisé en ce que** les ions (3) utilisés lors de l'étape d'implantation sont choisis parmi les ions de gaz rares et de gaz hydrogène.

3. Procédé selon l'une des revendications 1 ou 2, **caractérisé en ce que** ledit amincissement est effectué par une technique de rodage mécanique, de polissage mécano-chimique ou par attaque chimique, ou par une combinaison de ces techniques.

4. Procédé selon l'une quelconque des revendications 1 à 3, **caractérisé en ce que** la mise en contact intime est obtenue par une technique de collage par adhésion moléculaire renforcé par recuit à une température inférieure à la température minimale qui permet de provoquer une séparation entre les deux régions du substrat.

5. Procédé selon la revendication 4, **caractérisé en ce qu'**un recuit renforçant l'adhésion moléculaire est effectué en plusieurs phases alternant avec des phases d'amincissement.

6. Utilisation du procédé selon l'une quelconque des revendications précédentes pour obtenir un film mince (5) de silicium sur un support (6) en silice.

## Claims

1. Production method for a thin film made of a first material on a support made of a second material, said method comprising:
- an ionic implantation step during which a face (2) of a substrate (1) of said first material is bombarded with ions (3) in order to create a layer of micro-cavities (4) in the volume of the substrate and to a depth similar to the mean penetration depth of the ions, said layer separating the substrate (1) into two parts, the part located between said bombarded face (2) of substrate (1) and the layer of micro-cavities (4) constituting the thin film (5),
- a bonding step in which said bombarded face (2) of substrate (1) is put into close contact with a corresponding face of the support (6),
- a final heat treatment step intended to bring the layer of micro-cavities (4) to a temperature high enough to cause the two parts of the substrate (1) to separate,
**characterized in that** the method comprises the following steps :
- a step for bonding a substrate of said first material, said substrate having two main parallel faces, onto a first support element using close contact of one of the main faces of the substrate with a corresponding face of the first support element,
- a thinning step of said substrate on the other of its main sides, the thickness of the thinned element being such that the assembly, constituted by the elements bonded together by said close contact, can withstand the heat treatment step that causes said separation while conserving said close contact despite the stresses to which said elements are subject and that are due to the difference in their thermal dilation coefficients,
- an ionic implantation step during which the free main face of the thinned substrate is bombarded with ions,
- a step in which the thinned substrate is bonded onto a second support element by close contact of the bombarded face with a corresponding face of the second support element,
- a final heat treatment step intended to bring the micro-cavity layer to a temperature high enough to cause a cleavage along said micro-cavity layer.

2. Method of claim 1, **characterized in that** the ions (3) that are used in the implantation step are chosen from rare gas and hydrogen gas ions.

3. Method of claim 1 or 2, **characterized in that** said thinning is effected using mechanical grinding, chemical-mechanical polishing or by chemical etching, or using a combination of said techniques.

4. Method of any of claims 1 to 3, **characterized in that** close contact is achieved using a gluing technique involving molecular adhesion that is reinforced by annealing at a lower temperature than the minimum temperature required to cause the two parts of he substrate to separate.

5. Method of claim 4, **characterized in that** an annealing to reinforce the molecular adhesion is effected in several steps that alternate with the thinning phases.

6. Use of the method of any of the preceding claims to obtain a thin film (5) of silicon on a support (6) in silica.

## Patentansprüche

1. Verfahren zur Herstellung einer Dünnschicht aus einem ersten Material auf einem Träger aus einem zweiten Material, umfassen:
- einen Ionenimplantationsschritt, in dessen Verlauf eine Fläche (2) eines Substrats (1) mit Ionen (3) bombardiert wird, um in dem Volumen des Substrats und in einer ungefähr der mittleren Eindringtiefe der Ionen entsprechenden Tiefe eine das Substrat (1) in zwei Bereiche trennende Mikrohohlräume-Schicht (4) zu erzeugen, wobei der Bereich zwischen der bombardierten Fläche (2) des Substrats (1) und der Mikrohohlräume-Schicht (4) die Dünnschicht (5) bildet,
- einen Schritt zur Befestigung einer entsprechenden Fläche des Trägers (6) auf der bombardierten Fläche (2) des Substrats (1) durch Herstellung eines engen Kontakts,
- einen finalen Thermobehandlungsschritt, in dem die Mikrohohlräume-Schicht (4) auf eine Temperatur gebracht wird, die ausreicht, um eine Trennung zwischen den beiden Bereichen des Substrats (1) zu bewirken,
**dadurch gekennzeichnet, dass** es die folgenden Schritte umfasst:
- einen Schritt zur Befestigung des zwei parallele Hauptflächen aufweisenden Substrats aus dem genannten ersten Material auf einem ersten Trägerelement durch Herstellung eines engen Kontakts von einer der Hauptflächen des Substrats mit einer entsprechenden Fläche des ersten Trägerelements,
- einen Dünnungsschritt, darin bestehend, das genannte Substrat - ausgehend von seiner anderen Hauptfläche - zu dünnen, wobei die Dicke des gedünnten Substrats so ist, dass das Ganze, gebildet durch die mittels der genannten engen Kontaktherstellung aneinander befestigten Elemente, dem Thermobehandlungsschritt unterzogen werden kann, der die genannte Trennung bewirkt, wobei der genannte enge Kontakt erhalten bleibt, trotz der in den genannten Elementen induzierten und aus ihren unterschiedlichen Wärmedehnungskoeffizienten resultierenden Spannungen,
- einen Schritt zur Realisierung der Ionenimplantation, in dessen Verlauf die freie Hauptfläche des gedünnten Substrats mit Ionen bombardiert wird,
- einen Schritt zur Befestigung des gedünnten Substrats auf einem zweiten Trägerelement durch Herstellung eines engen Kontakts der bombardierten Fläche mit einer entsprechenden Fläche des zweiten Trägerelements,
- einen finalen Schritt zur Realisierung der Thermobehandlung, dazu bestimmt, die Mikrahohiräume-Schicht auf eine Temperatur zu bringen, die ausreicht, um eine Spaltung längs der Mikrohahlräume-Schicht zu bewirken.

2. Verfahren nach Anspruch 1, **dadurch gekennzeichnet, dass** die in dem Implantationsschritt benutzten Ionen (3) ausgewählt werden unter den Ionen von Edelgasen und von Wasserstoffgas.

3. Verfahren nach einem der Ansprüche 1 oder 2, **dadurch gekennzeichnet, dass** die genannte Dünnung durch mechanische Läppung, mechanisch-chemische Politur oder chemische Ätzung oder durch eine Kombination dieser Techniken realisiert wird.

4. Verfahren nach einem der Ansprüche 1 bis 3, **dadurch gekennzeichnet, dass** die Herstellung des engen Kontakts durch eine Klebetechnik des Typs Molekularadhäsion realisiert wird, verstärkt durch Tempern mit einer Temperatur unter der minimalen Temperatur, die ermöglicht, eine Trennung zwischen den beiden Bereichen des Substrats zu verursachen.

5. Verfahren nach Anspruch 4, **dadurch gekennzeichnet, dass** ein die Molekularadhäsion verstärkendes Tempern in mehreren mit Dünnungsphasen abwechselnde Phasen stattfindet.

6. Anwendung des Verfahrens nach einem der vorangehenden Ansprüche zur Herstellung einer Dünnschicht (5) aus Silcium auf einem Träger (6) aus Siliciumdioxid.
